# FASCICULE DE BREVET EUROPEEN

(11) **EP 2 487 793 B1**
(45) Date de publication et mention de la délivrance du brevet: **06.05.2015**
(21) Numéro de dépôt: 12153557.9
(22) Date de dépôt: 02.02.2012
(51) Int. Cl.: H03H 3/007, H03H 3/08, H03H 9/02, H03H 9/64, H03H 9/17, H01L 21/033

(54) **Procédé de réalisation d'un dispositif acoustique comprenant une structure de cristal phononique à inclusions de type conique qui contrôle la bande d'arrêt dudit dispositif**
Verfahren zur Herstellung einer akustischen Vorrichtung, die eine phononische Kristallstruktur mit konischen Einschlüssen umfasst, welche eine Bandsperre für die Vorrichtung einstellen
Method for manufacturing an acoustic device including a phononic-crystal structure with cone-shaped inclusions which determine a stop band of the acoustic device

(30) Priorité: 11.02.2011 FR 1151101
(43) Date de publication de la demande: 15.08.2012
(73) Titulaire: Commissariat à l'Énergie Atomique et aux Énergies Alternatives, 75015 Paris (FR)
(72) Inventeur: Gorisse, Marie, 79180 Chauray (FR); Reinhardt, Alexandre, 38400 Saint Martin d'Heres (FR)
(74) Mandataire: Esselin, Sophie

(56) Documents cités:
- JP-A- 60 002 948
- US-A1- 2004 192 060
- US-A1- 2009 295 505
- Sarah Benchabane: "Fabrication d'un cristal phononique piézoélectrique en niobate de lithium", Chapter 4 in THESIS titled: Guidage et filtrage des ondes dans les cristaux phononiques, 1 janvier 2006 (2006-01-01), pages 83-101, XP55025213, Extrait de l'Internet: URL:http://membres.multimania.fr/sbenchaba ne/publications/Benchabane_these.pdf [extrait le 2012-04-20]
- ASSOUAR B M ET AL: "Phononic crystals based on linbo3realized using domain inversion by electron-beam irradiation", IEEE TRANSACTIONS ON ULTRASONICS, FERROELECTRICS AND FREQUENCY CONTROL, IEEE, US, vol. 53, no. 2, 1 février 2008 (2008-02-01), pages 273-278, XP011225315, ISSN: 0885-3010
- J. VASSEUR ET AL: "Absolute forbidden bands and waveguiding in two-dimensional phononic crystal plates", PHYSICAL REVIEW B, vol. 77, no. 8, 1 février 2008 (2008-02-01), XP055007994, ISSN: 1098-0121, DOI: 10.1103/PhysRevB.77.085415
- BENCHABANE S ET AL: "Evidence for complete surface wave band gap in a piezoelectric phononic crystal", PHYSICAL REVIEW E (STATISTICAL, NONLINEAR, AND SOFT MATTER PHYSICS), AMERICAN PHYSICAL SOCIETY, COLLEGE PARK, MD, US, vol. 73, 9 juin 2006 (2006-06-09), pages 65601-1, XP007911745, ISSN: 1539-3755, DOI: 10.1103/PHYSREVE.73.065601

## Description

Le domaine de l'invention est celui des dispositifs acoustiques exploitant le blocage de la propagation des ondes acoustiques par une organisation généralement périodique de matériaux acoustiquement différents en vue de réaliser des fonctions de filtre électrique.

On entend par dispositif acoustique toute structure utilisant la propagation d'ondes acoustiques et notamment des résonateurs ou des filtres acoustiques.

De tels dispositifs présentent des fréquences de fonctionnement pouvant aller de quelques Hz à quelques GHz. Les applications potentielles de ces dispositifs peuvent concerner des lentilles acoustiques, des filtres RF pouvant être utilisés dans les communications sans fil et notamment dans la téléphonie mobile, ou bien encore concerner de nombreux dispositifs anti-vibration ou RF.

Selon l'art connu, comme notamment décrit dans l'article de M.S. Kushwaha, P. Halevi, L. Dobrzynski, B. Djafari-Rouhani, Acoustic Band Structure of Periodic Elastic Composites, Physical Review Letters, vol. 71 (13), pp. 2022-2025, 1993, les cristaux phononiques sont constitués par une organisation périodique de plusieurs, le plus souvent deux matériaux, acoustiquement différents. Ces systèmes présentent des bandes d'arrêt *(gap* en anglais), c'est-à-dire des fréquences pour lesquelles aucune onde acoustique ne peut se propager. Ces organisations peuvent être à une, deux ou trois dimensions. A une dimension, elles correspondent aux miroirs de Bragg comme décrit dans l'article de W.E. Newell, Face-mounted piezoelectric resonators, Proceedings of the IEEE vol 53, pp. 575-581, 1965, rencontrés notamment dans les filières BAW (Bulk Acoustic Resonator). Ces structures sont couramment utilisées dans l'industrie. Les structures à deux ou trois dimensions sont encore à l'état de recherche actuellement.

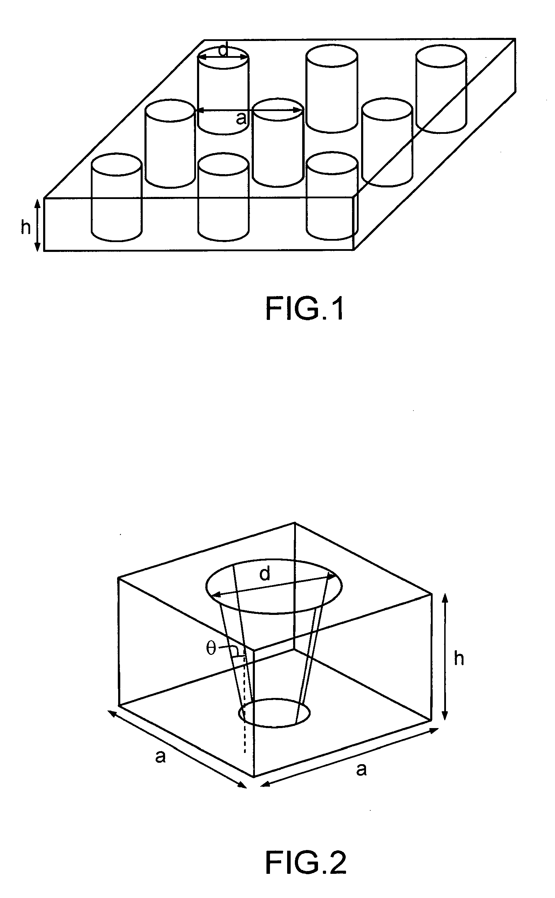

Selon l'art connu, ces structures sont généralement réalisées en creusant des trous dans un matériau comme illustré en figure 1 (a correspondant à la périodicité des motifs, h à leur hauteur et d à leur diamètre), et parfois en les remplissant partiellement ou complètement d'un autre matériau. Les trous réalisés tendent à être le plus cylindrique possible, mais il est bien connu qu'il n'est pas possible technologiquement de réaliser des cylindres parfaits. Dans les faits, les trous tendent à être de type conique. La thèse de Sarah Benchabane « Guidage et filtrage des ondes dans les cristaux phononiques », U.F.R. des sciences et techniques de l'université de Franche-Comté, 2006, explique que les trous réalisés pour des dispositifs à SAW sont gravés avec un demi-angle au sommet d'environ 20° (donc une pente à 70° dans le matériau). Cet angle entraine des fuites des ondes de surface dans le substrat, et pose donc problème. La littérature des cristaux phononiques dans des couches minces ne fait pas état de l'angle de gravure des inclusions, mais il est généralement admis que ce paramètre est un inconvénient, par analogie avec les systèmes à ondes acoustiques de surface SAW.

L'un des paramètres importants dans le domaine des cristaux phononiques est la largeur en fréquence de la bande d'arrêt. On cherche généralement à obtenir des bandes d'arrêt les plus larges possibles. Il est souvent possible d'élargir la bande d'arrêt en augmentant le diamètre des inclusions comme décrit dans l'article de S. Mohammadi, A.A. Eftekhar, A. Khelif, H. Moubchir, R. Westafer, W.D. Hunt, A. Adibi, Complete phononic bandgaps and bandgap maps in two-dimensional silicon phononic crystal plates, Electronic Letters, vol. 43 (16), pp. 898-899, 2007, (augmentation du paramètre d/a, comme schématisé en figure 1), mais on atteint rapidement des limites technologiques. En effet, la réalisation pratique des dispositifs ne permet pas de réaliser n'importe quelles dimensions. La diminution des dimensions entraîne une complexification des étapes technologiques, et par conséquent une augmentation des coûts.

Il a également été proposé par l'équipe du professeur Piazza une autre solution pour la réalisation de cristaux phononiques en AIN. En effet cette équipe propose des inclusions d'AIN dans une matrice d'air, ces inclusions étant reliées entre elles grâce à des « ponts ». Cette solution reste complexe car elle demande de bien maîtriser l'épaisseur des « ponts ». (N.K. Kuo, C. Zuo, G. Piazza, Microscale inverse acoustic band gap structure in aluminum nitride, Appl. Phys. Let., 95, n° 09093501, Sept. 2009, N.K. Kuo, C. Zuo, G. Piazza, Demonstration of inverse acoustic band gap structures in AIN and integration with piezoelectric contour mode wideband transducers, IEEE, 2009).

Dans ce contexte, la présente invention propose une solution permettant de contrôler, voire d'élargir les bandes d'arrêt en fréquence, obtenues pour des cristaux phononiques. En effet, le demandeur a mis en évidence que la largeur de cette bande d'arrêt est plus importante par exemple pour des trous coniques par comparaison avec des trous cylindriques, permettant par là même d'obtenir des bandes d'arrêt plus larges en fréquence tout en conservant des géométries réalisables technologiquement et permettant ainsi d'envisager de nouvelles applications, ou une réduction des coûts de fabrication.

Plus précisément, la présente invention a pour objet un procédé de réalisation d'un dispositif acoustique comprenant une structure de cristal phononique comprenant une première série d'inclusions réalisées dans un premier milieu réparties dans une matrice constituée par un second milieu, permettant le blocage de la propagation des ondes acoustiques dans une bande de fréquences dite bande d'arrêt, **caractérisé en ce qu'**il comporte les étapes suivantes :
- une étape de définition des paramètres géométriques desdites inclusions, lesdites inclusions comportant des parois en contact avec ladite matrice faisant au moins un premier angle θ dit angle de paroi, non nul avec la normale au plan de ladite structure, lesdits paramètres géométriques comprenant ledit premier angle de paroi, ladite étape comportant :
   - la détermination d'une fonction relative à l'évolution de la position en fréquence de ladite bande d'arrêt avec ledit angle de paroi et/ou la détermination d'une fonction relative à l'évolution de largeur de ladite bande d'arrêt avec ledit angle de paroi ;
   - la détermination dudit au moins premier angle θ pour une position en fréquence et/ou une largeur de la bande d'arrêt, choisies à partir de la ou des fonctions précédemment déterminées ;
- une étape de réalisation de ladite première série d'inclusions présentant au moins ledit premier angle de paroi, dans ladite matrice constituée par ledit second milieu.

Selon une variante de l'invention, l'étape de détermination d'une fonction est réalisée par une opération de simulation 3D réalisée par éléments finis et/ou par mesure d'expérience.

Selon une variante de l'invention, le procédé comprend les étapes suivantes :
- le dépôt d'une couche de matériau en AIN sur un substrat ;
- la réalisation d'un masque de résine sur la couche de matériau en AIN ;
- une opération de gravure pouvant être une opération de gravure sèche afin de définir des trous coniques présentant au moins ledit premier angle de paroi, dans la couche de matériau en AIN ;
- le retrait du masque de résine.

Selon une variante de l'invention, l'opération de gravure sèche est une opération de gravure RIE.

Selon une variante de l'invention, le procédé comprend sur un substrat SOI comprenant une couche supérieure de silicium à la surface d'une couche d'oxyde de silicium ;
- le dépôt d'une résine à la surface du substrat de SOI ;
- la définition de motifs gravés dans ladite couche de résine ;
- une étape de fluage de ladite résine, de manière à orienter les motifs de gravure ;
- une opération de gravure de la couche supérieure de silicium au travers desdits motifs orientés dans ladite résine de manière à définir des trous coniques présentant au moins ledit premier angle de paroi ;
- le retrait de ladite couche de résine comprenant des motifs de gravure.

Selon une variante de l'invention, les inclusions présentent des géométries de sections de type circulaires ou carrées ou hexagonales ou triangulaires.

Selon une variante de l'invention, la structure de cristal phononique est d'organisation périodique, la série d'inclusions étant répartie de manière périodique dans la matrice.

Selon une variante de l'invention, les inclusions sont disposées selon des arrangements périodiques obtenus par répétition d'une maille élémentaire de type hexagonale ou carrée ou triangulaire ou en nid d'abeille.

Selon une variante de l'invention, les inclusions sont des cônes dits fermés de manière à élargir au maximum la bande d'arrêt.

Selon une variante de l'invention, les inclusions présentant plusieurs angles de parois. Ce procédé comprend une étape de définition des paramètres géométriques desdites inclusions comportant :
- la détermination d'une fonction relative à l'évolution de la position en fréquence de ladite bande d'arrêt avec lesdits angles de paroi et/ou la détermination d'une fonction relative à l'évolution de largeur de ladite bande d'arrêt avec lesdits angles de paroi.

Selon une variante de l'invention, les inclusions sont réalisées dans une matrice hétérogène pouvant comprendre un empilement de couches.

Selon une variante de l'invention, les inclusions d'une série sont formées respectivement par plusieurs matériaux superposés et/ou juxtaposés.

Selon une variante de l'invention, ladite structure présente plusieurs séries d'inclusions différentes.

Selon une variante de l'invention, ladite structure présente plusieurs séries d'inclusions réalisées respectivement dans des matrices différentes.

Selon une variante de l'invention, les inclusions sont des trous.

Selon une variante de l'invention, les inclusions sont constituées de trous partiellement ou totalement remplis de matériau.

Selon une variante de l'invention, le procédé comporte en outre la réalisation d'une structure de miroir de Bragg supportant ladite structure phononique.

Selon une variante de l'invention, la structure phononique est une structure périodique à deux dimensions.

Selon une variante de l'invention, le cristal phononique à deux dimensions de ladite structure, a une épaisseur du même ordre de grandeur que le paramètre de maille du cristal.

L'invention sera mieux comprise et d'autres avantages apparaîtront à la lecture de la description qui va suivre donnée à titre non limitatif et grâce aux figures annexées parmi lesquelles :
- la figure 1 schématise une structure de cristal phononique à 2D selon l'art connu ;
- la figure 2 illustre un exemple de maille cristalline dans une structure de cristal phononique selon l'invention ;
- la figure 3 illustre une zone de Brillouin réduite pour une maille carrée ;
- la figure 4 illustre l'évolution de la largeur de la bande d'arrêt en fonction de l'angle interne des cônes dans un exemple de structure phononique selon l'invention ;
- la figure 5 illustre l'évolution de la position de la bande d'arrêt en fonction de l'angle des cônes dans un exemple de structure phononique selon l'invention ;
- la figure 6 illustre l'évolution de la bande d'arrêt pour différentes géométries d'inclusions selon la présente invention ;
- les figures 7a à 7d et 7e illustrent respectivement les différentes étapes d'un premier procédé de fabrication d'un exemple de structure phononique de nitrure d'aluminium selon l'invention et une vue de dessus de ladite structure ainsi obtenue par le procédé utilisant une étape de gravure humide ;
- les figures 8a à 8d illustrent respectivement les différentes étapes d'un second procédé de fabrication d'un exemple de structure phononique de nitrure d'aluminium selon l'invention dudit procédé, utilisant des étapes de gravure sèche ;
- les figures 9a à 9f illustrent les différentes étapes d'un premier procédé permettant de maîtriser les pentes de gravure ;
- les figures 10a à 10c illustrent les différentes étapes d'un second procédé permettant de maîtriser les pentes de gravure ;
- la figure 11 illustre une variante de l'invention dans laquelle, les motifs présentent plusieurs angles de paroi ;
- les figures 12a à 12f illustrent les différentes étapes d'un second procédé de fabrication d'un exemple de structure phononique réalisé dans un substrat de SOI.

De manière générale, le procédé de la présente invention permet de réaliser un dispositif acoustique de l'invention comportant une structure phononique préférentiellement à 2 dimensions comprenant des motifs le plus souvent périodiques tels qu'ils permettent de contrôler voire d'élargir les bandes d'arrêt de la structure de cristal phononique.

Lorsqu'un cristal phononique à deux dimensions a une épaisseur faible, du même ordre de grandeur que le paramètre de maille, on peut aussi dire qu'il est à 2,5 dimensions.

La présente invention peut concerner des structures sur couches minces composées de deux matériaux différents, mais le principe est aussi applicable à des structures plus complexes à deux dimensions (structures massives : cristaux phononiques en surface d'un substrat, ou sur miroir de Bragg, ou à plus de deux matériaux). Dans tous les cas il s'agit d'ondes acoustiques, qu'il s'agisse d'ondes de volume (BAW) ou d'ondes de plaques (ondes de Lamb).

La figure 2 illustre un exemple de motifs périodiques pouvant avantageusement être utilisés dans un cristal phononique d'un dispositif acoustique de l'invention, l'angle θ correspondant à l'angle dit de paroi, les inclusions étant dans le cas présent des trous.

Le demandeur a constaté que plus l'angle θ défini par rapport à la normale au plan de la structure est élevé et plus la largeur de la bande d'arrêt est grande. Cet effet est contrecarré par le fait que, si l'angle est trop élevé, les trous se referment, et donc la bande d'arrêt se referme aussi progressivement.

L'augmentation de l'angle θ a aussi pour effet d'augmenter la fréquence centrale de la bande d'arrêt, et ce jusqu'à ce que la bande d'arrêt se referme complètement.

Le demandeur a ainsi vaincu un préjugé. En effet, selon l'art antérieur publié, le fait de faire des cônes est considéré comme un défaut de fabrication comme notamment décrit dans les articles S. Mohammadi, A.A. Eftekhar, A. Khelif, H. Moubchir, R. Westafer, W.D. Hunt, A. Adibi, Complete phononic bandgaps and bandgap maps in two-dimensional silicon phononic crystal plates, Electronic Letters, vol. 43 (16), pp. 898-899, 2007 et R.H. Olsson, I.F. EI-Kady, M.F. Su, M.R. Tuck, J.G. Fleming, Microfabricated VHF acoustic crystal and waveguides, Sens. & Act., 145-146. Iss. SI, p. 87-94, Nov. 2008 ; S. Mohammadi, A.A. Eftekhar, A. Khelif, W. Hunt, A. Adibi, Evidence of large high frequency complete phononic band gaps in silicon phononic crystal plates, Appl. Phys. Let., 92-22, n° 221905, Jun. 2008.

La présente invention se situe donc à l'opposé de cette tendance : pour obtenir une grande bande d'arrêt, il convient d'avoir une structure avec des trous périodiques de forme par exemple conique, l'optimum étant obtenu avec un angle interne permettant aux trous d'être refermés, soit dans une gamme d'angles allant de 15° à 85°.

On peut choisir volontairement de ne pas se placer à l'optimum mais de prendre un angle intermédiaire pour avoir une largeur de bande d'arrêt déterminée. Dans ce cas on calcule la relation entre l'angle des inclusions et la largeur de la bande en fonction de l'agencement des inclusions, de leur forme, de leur taille et des matériaux utilisés.

Ainsi, selon l'exemple illustré en figure 2, la structure de cristal phononique comporte des inclusions matérialisées par des trous de section de type circulaire, le milieu constitutif des inclusions étant par exemple de l'air dans une matrice solide, l'organisation de ces trous étant répartie en maille carrée.

Selon d'autres variantes, la structure de cristal phononique peut comprendre :
- des inclusions de différentes sections : circulaires, carrées, hexagonales, triangulaires,... ;
- des inclusions dans une matrice hétérogène (par exemple dans une membrane composée de deux couches, notamment du SiO₂ et de l'AIN) ;
- des inclusions présentant plusieurs angles, soit dans un même matériau, soit dans plusieurs matériaux différents ;
- des trous remplis de matériaux, partiellement ou entièrement (comme décrit dans l'article de R.H. Olsson, I.F. EI-Kady, M.F. Su, M.R. Tuck, J.G. Fleming, Microfabricated VHF acoustic crystal and waveguides, Sens. & Act., 145-146. Iss. SI, p. 87-94, Nov. 2008);
- des inclusions solides une matrice fluide (comme de l'air), reliées entre elles par des « ponts » (comme décrit dans les articles de N.K. Kuo, C. Zuo, G. Piazza, Microscale inverse acoustic band gap structure in aluminum nitride, Appl. Phys. Let., 95, n° 093501, Sept. 2009, N.K. Kuo, C. Zuo, G. Piazza, Demonstration of inverse acoustic band gap structures in AIN and integration with piezoelectric contour mode wideband transducers, IEEE, 2009);

Toutes ces structures de cristal phononique peuvent être élaborées sous forme de membrane ou sur substrat (miroir de Bragg ou directement sur substrat), pour réaliser un dispositif acoustique selon la présente invention.

### Premier exemple de structure phononique pouvant être utilisée dans un dispositif acoustique de l'invention :

Cet exemple de structure comprend un cristal phononique à 2,5 dimensions constitué de trous constitutifs des inclusions, dans une membrane en nitrure d'aluminium (AIN) et comportant un agencement périodique carré de ces trous.

La géométrie des trous est défini par les rapports de paramètres suivants : d/a = 0,8 et h/a = 0,6.

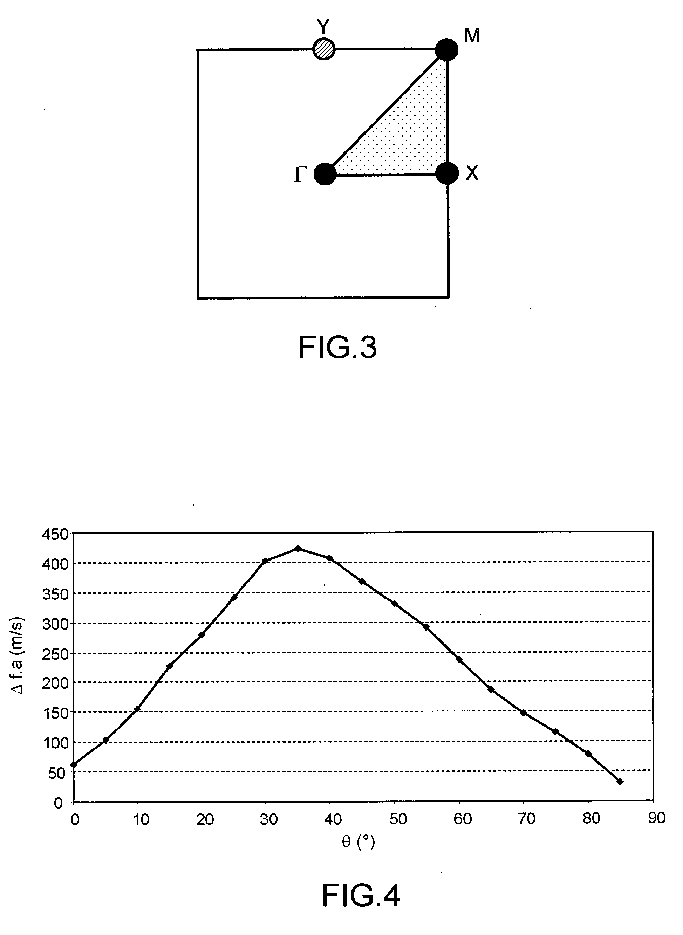

Avec une telle géométrie de trous, le demandeur a déterminé par simulation 3D réalisée par éléments finis à l'aide du logiciel commercial Comsol Multiphysics® les bandes d'arrêt de ce type de structure phononique, selon une méthode présentée dans l'article M. Gorisse, A. Reinhardt, E. Defaÿ, M. Aïd, Conception de cristaux phononiques 2D dans une membrane de nitrure d'aluminium, Journées nationales du réseau doctoral en microélectronique, juin 2010, Montpellier, France, et s'est focalisé sur des bandes d'arrêt pour des ondes se propageant selon la direction ┌X de la zone de Brillouin réduite pour une maille carrée et illustrée sur la figure 3.

Dans un premier temps, afin d'évaluer les propriétés d'une telle structure, le demandeur a également analysé un cristal phononique constitué de trous cylindriques percés dans une membrane d'aluminium avec les dimensions choisies suivantes :
- d/a = 0,8
- h/a = 0,6
- θ = 0°

Avec ces dimensions, il y a apparition d'une bande d'arrêt pour des fréquences normalisées (fréquence multipliée par le paramètre de maille a) comprises entre 2200 et 2375 m/s.

Une telle structure est adaptée dans le cadre de la présente invention et les inclusions sont constituées par des trous de géométrie particulière. Pour cela les parois internes des trous font un angle non nul avec la normale au plan de ladite structure, constituant par là même des trous coniques.

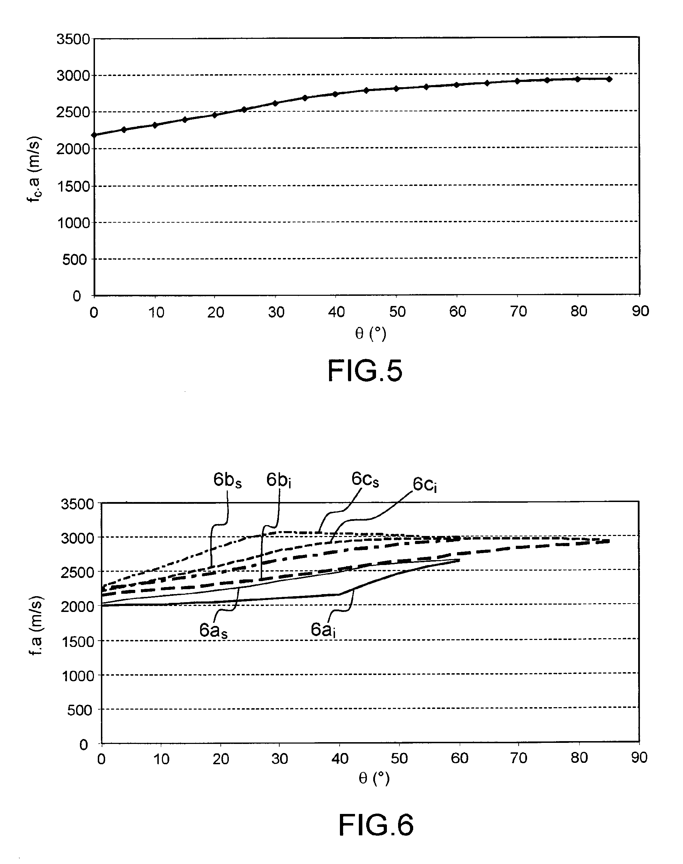

Les figures 4 et 5 illustrent à cet effet la largeur de la bande d'arrêt et la fréquence centrale de ladite bande d'arrêt, obtenues en fonction de l'angle de paroi des trous coniques.

Sur ces figures, il apparaît que les bandes d'arrêt sont plus larges et plus hautes en fréquence lorsqu'on augmente le demi-angle au sommet des cônes, jusqu'à atteindre un maximum correspondant à une géométrie dans laquelle les trous se referment et correspondant ainsi à un optimum pour la largeur de la bande d'arrêt, et ce pour un angle d'environ 35°.

De plus, il apparaît que la bande d'arrêt est de plus en plus haute en fréquence quand on augmente θ, et ce sans distinction pour des trous débouchants ou non.

La figure 6 présente les fréquences hautes (courbes 6aₛ, 6bₛ, 6cₛ) et basses (courbes 6aᵢ, 6bᵢ, 6cᵢ) des bandes d'arrêt pour une valeur de d/a = 0,8 et pour différentes valeurs de h/a. Toutes ces géométries présentent le même type de courbes : plus l'angle est élevé, plus la bande d'arrêt est large, jusqu'à atteindre une largeur maximale à l'angle pour lequel les trous se referment, puis la largeur diminue rapidement après ce maximum.

Pour obtenir une bande d'arrêt large, il existe donc un angle optimal qui dépend des matériaux en présence, de la disposition des trous et des dimensions réalisées. Dans le présent exemple, avec un cristal phononique constitué de trous percés dans une membrane en AIN, avec une disposition carrée en prenant d/a = 0.6 et h/a = 0.8, l'angle optimal est ainsi d'environ 35° pour la largeur de la bande passante.

Le demandeur a remarqué que la conicité des inclusions favorisait la conversion de modes à l'intérieur du cristal phononique. Cet effet permet d'exciter plus facilement tous les modes du cristal, évitant ainsi des phénomènes parasites qui agissent sur la transmission de la structure et qui pourraient fausser les propriétés effectives du cristal, comme par exemple ceux rencontrés dans Y. M. Soliman, M. F. Su, Z. C. Leseman, C. M. Reinke, 1. EI-Kady, and R. H. Olsson III4, Phononic crystals operating in the gigahertz range with extremely wide band gaps, Applied Physics Letters 97, n° 193502, 2010.

### Premier exemple de procédé de fabrication de dispositif acoustique selon l'invention :

La structure de cristal phononique est réalisée dans une membrane d'AIN suspendue, la membrane suspendue pourrait tout aussi bien être remplacée par une fine couche à la surface d'une structure de miroir de Bragg ou sur substrat directement.

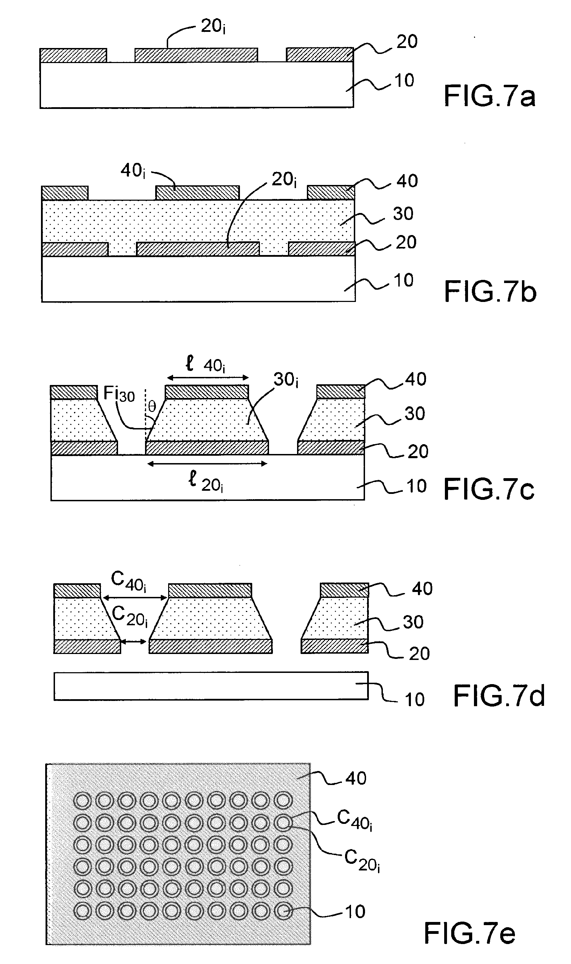

Comme illustré en figure 7a, sur un substrat 10 pouvant typiquement être en silicium, on dépose une couche 20 destinée à permettre l'élaboration d'un premier masque de gravure. Il peut typiquement s'agir d'une couche de molybdène d'épaisseur d'environ 0,3 µm, il pourrait également s'agir de platine ou de tout autre matériau permettant de bien structurer l'AIN. On procède à des étapes classiques de photolithographie, gravure sèche et retrait de résine pour définir de manière classique des premiers motifs dits de gravure 20i.

On procède alors au dépôt d'une couche 30 de nitrure d'aluminium AIN d'épaisseur environ 0,3 µm, puis au dépôt d'une seconde couche 40 destinée à constituer un second masque de gravure, dans lequel on définit par photolithographie, gravure sèche et retrait de résine des seconds motifs dits de gravure 40i comme illustré en figure 7b.

On procède à une étape de gravure humide de l'AIN en utilisant par exemple une solution de H₃PO₄ à chaud, comme illustré en figure 7c. Il est à noter que pour obtenir des trous avec des parois latérales Fᵢ₃₀, présentant un angle de paroi θ non nul, il est prévu que les motifs de gravure 20i et 40i présentent des dimensions latérales I₂₀ᵢ et I₄₀ᵢ, différentes.

Afin de libérer la membrane, on procède enfin à une étape de gravure du silicium au difluorure de xénon XeF₂, comme illustré en figure 7d.

La figure 7e illustre une vue de dessus de la structure phononique ainsi obtenue, mettant en évidence les doubles circonférences C₂₀ᵢ et C₄₀ᵢ, dues à la conicité des trous.

L'avantage principal de ce mode de réalisation est qu'il permet d'atteindre tout angle inférieur à environ 30°, cet angle correspondant à un plan cristallin de l'AIN pour lequel l'attaque chimique est extrêmement ralentie, et quasiment bloquée. Néanmoins, ce type de procédé ne permet pas de réaliser des motifs de très faibles dimensions (ouvertures inférieures à 10 µm).

### Second exemple de procédé de fabrication de dispositif acoustique selon l'invention :

Selon ce second procédé, on utilise un procédé de gravure sèche et non plus humide comme décrit dans le premier exemple.

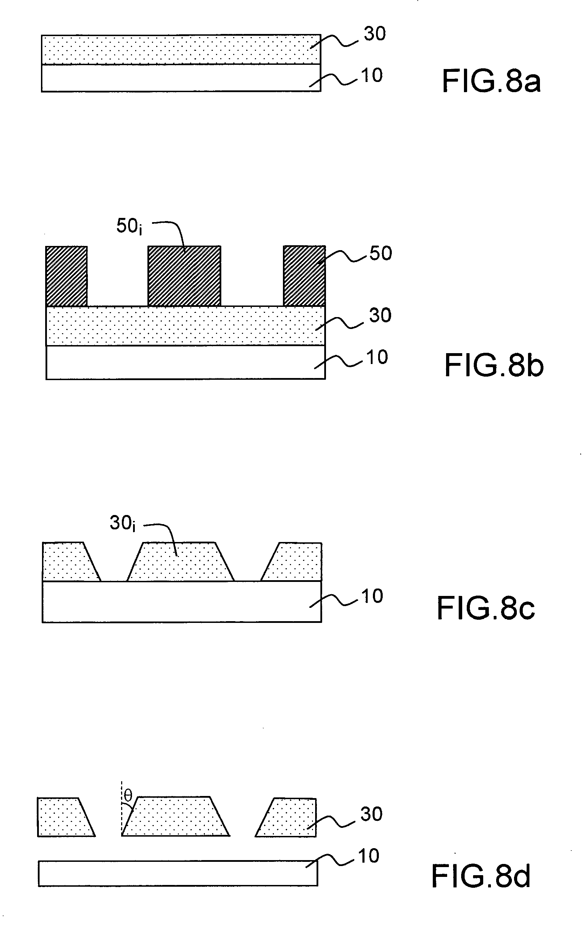

Comme illustré en figure 8a, on procède au dépôt direct d'une couche de nitrure d'alumium 30 d'environ 2 µm directement sur un substrat de silicium 10.

On procède alors au dépôt d'une couche épaisse de résine 50 (environ 4 µm) dans laquelle on définit des motifs de gravure 50i comme illustré en figure 8b.

On procède à une étape de gravure sèche par exemple par procédé de gravure ionique réactive, procédé couramment dénommé procédé RIE « Reactive-lon Etching » afin de définir les trous coniques entre motifs 30i et l'on procède enfin au retrait de la couche de résine épaisse comme illustré en figure 8c.

Ce procédé est réalisable sur des trous de petite taille (de l'ordre du µm). Il permet de viser un optimum aux alentours de 30°. Au-dessus de 30° la gravure se heurte à un plan cristallin de l'AIN et ne se fait plus correctement.

Dans le cas d'une gravure sèche, la maîtrise de l'angle de gravure se fait par l'optimisation du procédé en vue d'atteindre une sélectivité de gravure entre le masque en résine et la couche que l'on désire graver. Ceci se fait par ajustement des proportions du mélange gazeux introduit dans le réacteur de gravure (par exemple, la quantité d'oxygène), la pression dans l'enceinte, ainsi que les tensions d'accélération des ions responsables de la gravure. Grâce à cette sélectivité, toute pente initiale dans la résine se retrouve transférée de manière homothétique (selon un rapport correspondant justement à la sélectivité de gravure) dans la couche gravée. La pente initiale du masque de résine est elle-même maîtrisée selon deux manières :
- on peut utiliser le phénomène (habituellement un défaut) de facettage qui consiste à observer un facettage des angles du masque de résine au cours de la gravure
- ou l'on peut délibérément forcer une pente dans les motifs de résine en venant chauffer celle-ci à une température élevée (par exemple, 200°C pendant 15 min) de manière à la faire fluer.

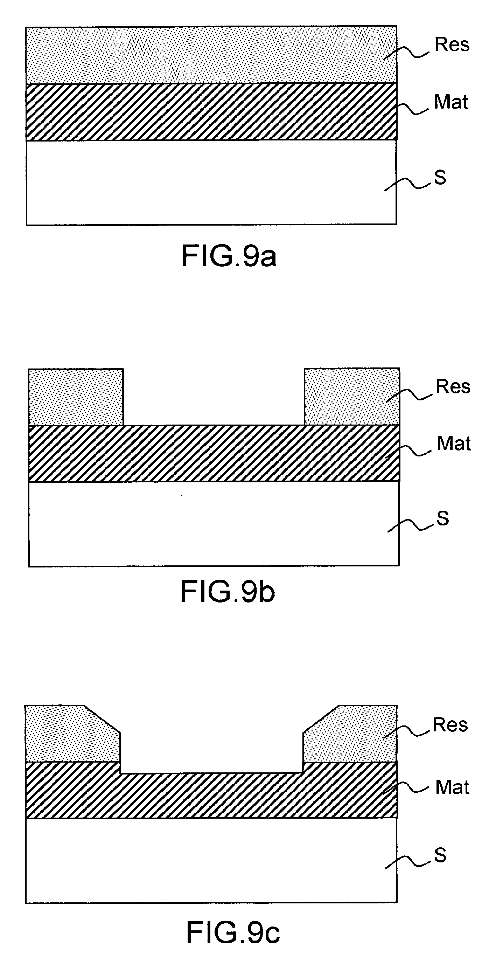

Une première variante de déroulement de la gravure est illustrée grâce aux figures 9a à 9f.

Dans une première étape on procède à la réalisation d'une matrice Mat sur un substrat S, ladite matrice étant recouverte d'une couche de résine Res, comme illustré en figure 9a.

Dans une seconde étape, on procède à une opération de photolithographie, puis insolation et développement de la résine, suivi d'un recuit de cette dernière comme illustré en figure 9b.

Dans une troisième étape, on réalise le début de l'opération de gravure en commençant à facetter le masque de résine comme illustré en figure 9c.

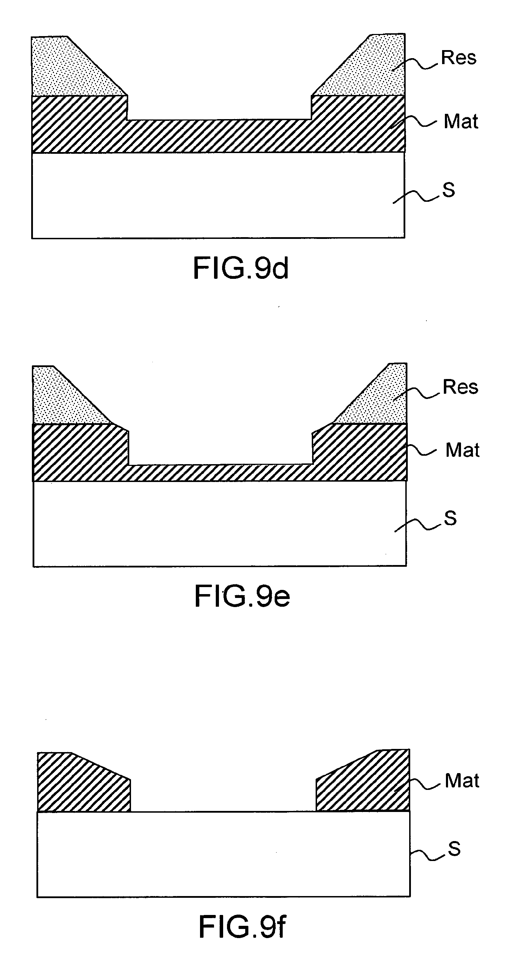

On continue l'opération de gravure : le facettage atteint toute la hauteur du masque de résine comme illustré en figure 9d.

On procède alors au transfert de la pente de la résine vers la couche de matrice comme illustré en figure 9e.

On réalise ensuite le retrait de la résine en fin de gravure comme illustré en figure 9f, laissant à nu la matrice gravée sur le substrat.

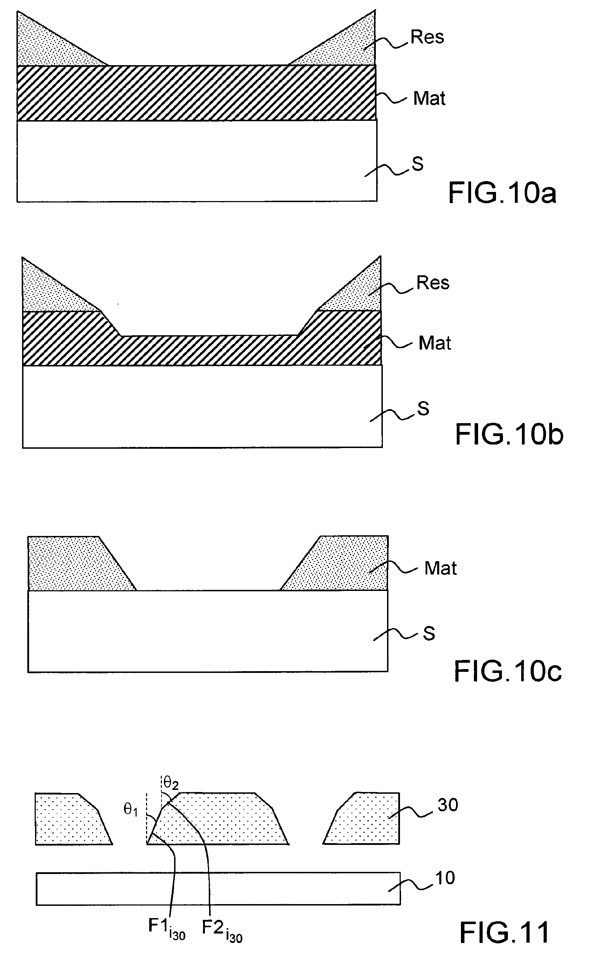

Selon une seconde variante, mieux maîtrisée, on vient procéder à un fluage de la résine comme illustré grâce aux figures 10a à 10c.

Dans une première étape, on effectue le fluage de la résine Res par exemple à 200°C pendant environ 15 minutes comme illustré en figure 10a, à la surface de la couche de matrice Mat à la surface du substrat S.

Durant la gravure, on réalise le transfert de la pente de la résine vers la couche de matrice comme illustré en figure 10b.

On procède alors un retrait de la résine en fin de gravure comme illustré en figure 10c, pour laisser à nu la matrice gravée.

On peut obtenir des résultats similaires en utilisant un masque dur au lieu du masque de résine. Dans ce cas on vient déposer une couche supplémentaire (par exemple du SiO₂ ou du SiN) qui présente une forte sélectivité de gravure par rapport à l'AIN. Cette couche est « patternée » par lithographie (en visant l'angle voulu), gravure, puis stripping. On vient ensuite graver l'AIN en transférant l'angle, puis on retire le masque dur par une autre gravure.

Une variante de ce procédé précédemment décrit en figures 8a à 8d et illustrée en figure 11 consiste à graver successivement des trous avec plusieurs angles de paroi θ₁ et θ₂, définissant plusieurs flancs de parois F₁ᵢ₃₀ et F₂ᵢ₃₀ et ce en réglant successivement des paramètres de gravure différents

### Troisième exemple de procédé de fabrication de dispositif acoustique selon l'invention :

Selon cet exemple, la structure phononique est réalisée directement dans un substrat de SOI.

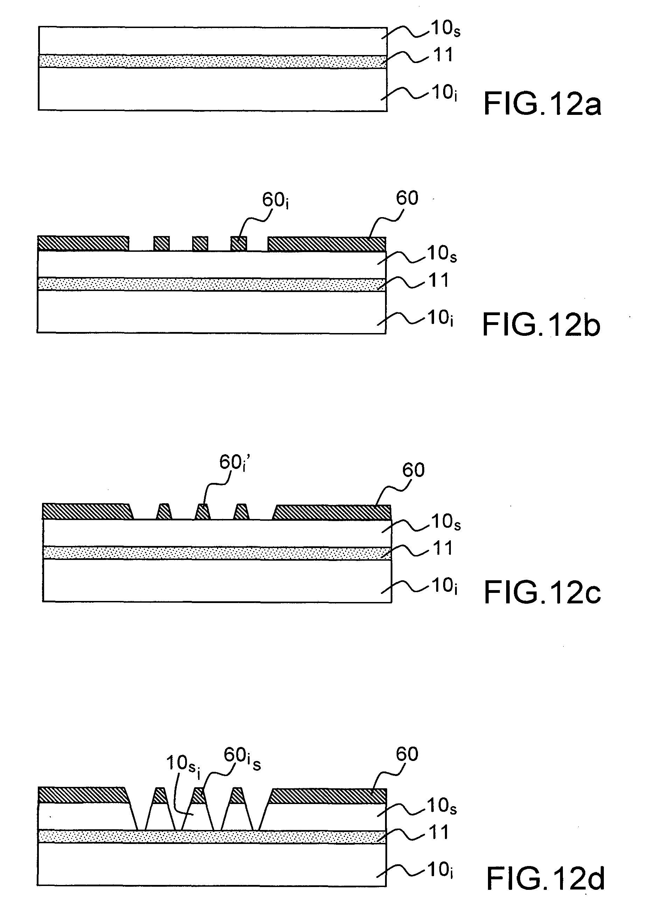

Pour cela et comme illustré en figure 12a, on utilise un substrat 10 de SOI comprenant une couche 11 de SiO₂ séparant ainsi le substrat en deux parties 10i et 10s de silicium.

On procède alors au dépôt d'une couche de résine 60, puis à des opérations de lithographie et gravure de la résine de manière à définir des motifs de résine 60i pour la gravure, comme représenté en figure 12b.

On procède alors à une étape de fluage de la résine et ce par chauffage, de manière à orienter les flancs des motifs de gravure et obtenir ainsi des motifs de gravure 60i' modifiés avec des flancs obliques, comme illustrés en figure 12c.

On procède ainsi à la gravure du silicium au travers desdits motifs 60i' modifiés, comme illustré en figure 12d, de manière à former les trous coniques de la structure phononique ainsi réalisée entre motifs de silicium 10s.

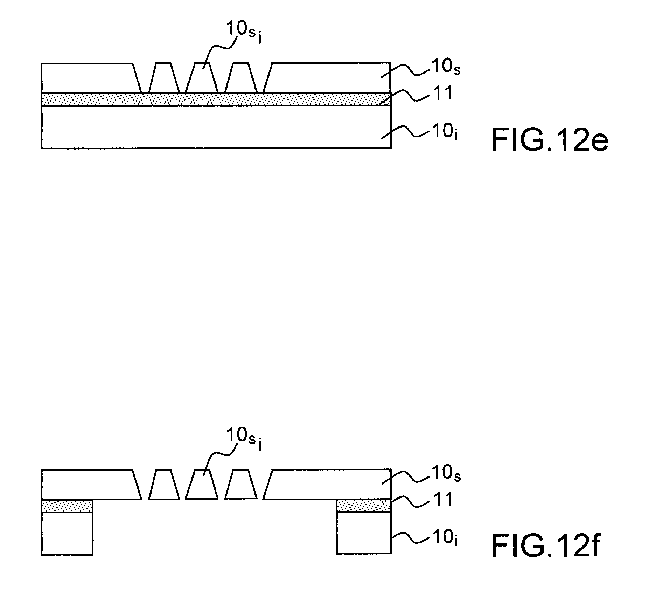

On procède alors au retrait de ladite résine comme illustré en figure 12e.

Puis, on réalise la libération de la structure pour réaliser la membrane, par gravure profonde du silicium en face arrière, comme illustré en figure 12f.

## Revendications

1. Procédé de réalisation d'un dispositif acoustique comprenant une structure de cristal phononique comprenant une première série d'inclusions réalisées dans un premier milieu réparties dans une matrice constituée par un second milieu, permettant le blocage de la propagation des ondes acoustiques dans une bande de fréquences dite bande d'arrêt, **caractérisé en ce qu'**il comporte les étapes suivantes :
- une étape de définition des paramètres géométriques desdites inclusions, lesdites inclusions comportant des parois en contact avec ladite matrice faisant au moins un premier angle (θ) dit angle de paroi, non nul avec la normale au plan de ladite structure, lesdits paramètres géométriques comprenant ledit premier angle de paroi, ladite étape comportant :
• la détermination d'une fonction relative à l'évolution de la position en fréquence de ladite bande d'arrêt avec ledit angle de paroi et/ou la détermination d'une fonction relative à l'évolution de largeur de ladite bande d'arrêt avec ledit angle de paroi ;
• la détermination dudit au moins premier angle (θ) pour une position en fréquence et/ou une largeur de la bande d'arrêt choisies, à partir de la ou des fonctions précédemment déterminées ;
- une étape de réalisation de ladite première série d'inclusions présentant au moins ledit premier angle de paroi, dans ladite matrice constituée par ledit second milieu.

2. Procédé de réalisation d'un dispositif acoustique comprenant une structure de cristal phononique selon la revendication 1, **caractérisé en ce que** l'étape de détermination d'une fonction est réalisée par une opération de simulation 3D réalisée par éléments finis et/ou par mesure d'expérience.

3. Procédé de réalisation d'un dispositif acoustique comprenant une structure de cristal phononique selon l'une des revendications 1 ou 2, **caractérisé en ce que** l'étape de réalisation de ladite première série d'inclusions comprend :
- le dépôt d'une couche de matériau en AIN sur un substrat ;
- la réalisation d'un masque de résine sur la couche de matériau en AlN ;
- une opération de gravure pouvant être une opération de gravure sèche afin de définir des trous coniques présentant au moins ledit premier angle de paroi, dans la couche de matériau en AlN ;
- le retrait du masque de résine.

4. Procédé de réalisation d'un dispositif acoustique comprenant une structure de cristal phononique selon la revendication 3, **caractérisé en ce que** l'opération de gravure sèche est une opération de gravure RIE.

5. Procédé de réalisation d'un dispositif acoustique comprenant une structure de cristal phononique selon l'une des revendications 1 ou 2, **caractérisé en ce qu'**il comprend sur un substrat SOI comprenant une couche supérieure de silicium à la surface d'une couche d'oxyde de silicium ;
- le dépôt d'une résine à la surface du substrat de SOI ;
- la définition de motifs gravés dans ladite couche de résine ;
- une étape de fluage de ladite résine, de manière à orienter les motifs de gravure ;
- une opération de gravure de la couche supérieure de silicium au travers desdits motifs orientés dans ladite résine de manière à définir des trous coniques présentant au moins ledit premier angle de paroi ;
- le retrait de ladite couche de résine comprenant des motifs de gravure.

6. Procédé de réalisation d'un dispositif acoustique selon l'une des revendications 1 à 5, **caractérisé en ce que** les inclusions présentent des géométries de sections de type circulaires ou carrées ou hexagonales ou triangulaires.

7. Procédé de réalisation d'un dispositif acoustique comprenant une structure de cristal phononique selon l'une des revendications 1 à 6, **caractérisé en ce que** la structure de cristal phononique est d'organisation périodique, la série d'inclusions étant répartie de manière périodique dans la matrice.

8. Procédé de réalisation d'un dispositif acoustique comprenant une structure de cristal phononique selon la revendication 7, **caractérisé en ce que** les inclusions sont disposées selon des arrangements périodiques obtenus par répétition d'une maille élémentaire de type hexagonale ou carrée ou triangulaire ou en nid d'abeille.

9. Procédé de réalisation d'un dispositif acoustique comprenant une structure de cristal phononique selon l'une quelconque des revendications 1 à 8, **caractérisé en ce que** les inclusions sont des cônes dits fermés de manière à élargir au maximum la bande d'arrêt.

10. Procédé de réalisation d'un dispositif acoustique comprenant une structure de cristal phononique selon l'une des revendications 1 à 9, **caractérisé en ce que**, les inclusions présentant plusieurs angles de parois (θ₁, θ₂), il comprend une étape de définition des paramètres géométriques desdites inclusions comportant :
• la détermination d'une fonction relative à l'évolution de la position en fréquence de ladite bande d'arrêt avec lesdits angles de paroi et/ou la détermination d'une fonction relative à l'évolution de largeur de ladite bande d'arrêt avec lesdits angles de paroi.

11. Procédé de réalisation d'un dispositif acoustique comprenant une structure de cristal phononique selon l'une des revendications 1 à 10, **caractérisé en ce que** les inclusions sont réalisées dans une matrice hétérogène pouvant comprendre un empilement de couches.

12. Procédé de réalisation d'un dispositif acoustique comprenant une structure de cristal phononique selon l'une des revendications 1 à 11, **caractérisé en ce que** les inclusions d'une série sont formées respectivement par plusieurs matériaux superposés et/ou juxtaposés.

13. Procédé de réalisation d'un dispositif acoustique comprenant une structure de cristal phononique selon l'une des revendications précédentes, **caractérisé en ce que** ladite structure présente plusieurs séries d'inclusions différentes.

14. Procédé de réalisation d'un dispositif acoustique comprenant une structure de cristal phononique selon l'une des revendications précédentes, **caractérisé en ce que** ladite structure présente plusieurs séries d'inclusions réalisées respectivement dans des matrices différentes.

15. Procédé de réalisation d'un dispositif acoustique comprenant une structure de cristal phononique selon l'une des revendications précédentes, **caractérisé en ce que** les inclusions sont des trous.

16. Procédé de réalisation d'un dispositif acoustique comprenant une structure de cristal phononique selon la revendication 15, **caractérisé en ce que** les inclusions sont constituées de trous partiellement ou totalement remplis de matériau.

17. Procédé de réalisation d'un dispositif acoustique comprenant une structure de cristal phononique selon l'une des revendications précédentes, **caractérisé en ce qu'**il comporte en outre la réalisation d'une structure de miroir de Bragg supportant ladite structure phononique.

18. Procédé de réalisation d'un dispositif acoustique comprenant une structure de cristal phononique selon l'une des revendications précédentes, **caractérisé en ce que** la structure phononique est une structure périodique à deux dimensions.

19. Procédé de réalisation d'un dispositif acoustique comprenant une structure de cristal phononique selon la revendication 18, **caractérisé en ce que** le cristal phononique à deux dimensions de ladite structure, a une épaisseur du même ordre de grandeur que le paramètre de maille du cristal.

## Patentansprüche

1. Verfahren zur Herstellung einer akustischen Vorrichtung, die eine phononische Kristallstruktur umfasst, die eine erste Reihe von Einschlüssen umfasst, die in einem ersten Milieu realisiert sind, die in einer Matrix verteilt sind, die aus einem zweiten Milieu besteht, so dass die Verbreitung der Schallwellen in einem als Stoppband bezeichneten Frequenzband blockierbar ist, **dadurch gekennzeichnet, dass** es die folgenden Schritte aufweist:
- einen Definitionsschritt der geometrischen Parameter der Einschlüsse, wobei die Einschlüsse Wände im Kontakt mit der Matrix aufweisen, die mindestens einen als Wandwinkel bezeichneten ersten Winkel (θ) ungleich Null mit der Normalen zur Ebene der Struktur bilden, wobei die geometrischen Parameter den ersten Wandwinkel umfassen, wobei der Schritt aufweist:
• das Bestimmen einer Funktion relativ zur Entwicklung der Frequenzpositionierung des Stoppbands mit dem Wandwinkel und/oder das Bestimmen einer Funktion relativ zur Entwicklung der Breite des Stoppbands mit dem Wandwinkel,
• das Bestimmen des mindestens ersten Winkels (θ) für eine gewählte Frequenzpositionierung und/oder eine gewählte Breite des Stoppbands ausgehend von der oder den zuvor bestimmten Funktionen,
- einen Realisierungsschritt der ersten Reihe von Einschlüssen, die mindestens den ersten Wandwinkel aufweisen, in der von dem zweiten Milieu gebildeten Matrix.

2. Verfahren zur Herstellung einer akustischen Vorrichtung, die eine phononische Kristallstruktur umfasst, nach Anspruch 1, **dadurch gekennzeichnet, dass** der Bestimmungsschiitt einer Funktion durch eine 3D-Simulationsoperation durchgeführt wird, die mit fertigen Elementen und/oder durch Erfahrungsmessung durchgeführt wird.

3. Verfahren zur Herstellung einer akustischen Vorrichtung, die eine phononische Kristallstruktur umfasst, nach einem der Ansprüche 1 oder 2, **dadurch gekennzeichnet, dass** der Realisierungsschritt der ersten Serien von Einschlüssen umfasst:
- das Aufbringen einer AIN-Materialschicht auf ein Substrat,
- das Herstellen einer Harzmaske auf der AIN-Materialschicht,
- eine Gravuroperation, die eine trockene Gravuroperation sein kann, um konische Löcher zu definieren, die mindestens den ersten Wandwinkel aufweisen, in der AIN-Materialschicht,
- das Entfernen der Harzmaske.

4. Verfahren zur Herstellung einer akustischen Vorrichtung, die eine phononische Kristallstruktur umfasst, nach Anspruch 3, **dadurch gekennzeichnet, dass** die trockene Gravuroperation eine RIE-Gravuroperation ist.

5. Verfahren zur Herstellung einer akustischen Vorrichtung, die eine phononische Kristallstruktur umfasst, nach einem der Ansprüche 1 oder 2, **dadurch gekennzeichnet, dass** es auf einem SOI-Substrat, das eine obere Siliziumschicht auf der Oberfläche einer Siliziumoxidschicht umfasst, umfasst:
- das Aufbringen eines Harzes auf der Oberfläche des SOI-Substrats,
- das Definieren von in die Harzschicht gravierten Motiven,
- einen Fließschritt des Harzes, um die Gravurmotive auszurichten,
- eine Gravuroperation der oberen Siliziumschicht durch Motive hindurch, die in der Harzschicht ausgerichtet sind, um konische Löcher zu definieren, die mindestens den ersten Wandwinkel aufweisen,
- das Entfernen der die Gravurmotive umfassenden Harzschicht.

6. Verfahren zur Herstellung einer akustischen Vorrichtung nach einem der Ansprüche 1 bis 5, **dadurch gekennzeichnet, dass** die Einschlüsse Querschnittsgeometrien runden oder viereckigen oder sechseckigen oder dreieckigen Typs aufweisen.

7. Verfahren zur Herstellung einer akustischen Vorrichtung, die eine phononische Kristallstruktur umfasst, nach einem der Ansprüche 1 bis 6, **dadurch gekennzeichnet, dass** die phononische Kristallstruktur periodisch organisiert ist, wobei die Reihe von Einschlüssen periodisch in der Matrix verteilt ist.

8. Verfahren zur Herstellung einer akustischen Vorrichtung, die eine phononische Kristallstruktur umfasst, nach Anspruch 7, **dadurch gekennzeichnet, dass** die Einschlüsse gemäß periodischen Anordnungen angeordnet sind, die durch Wiederholung eines elementaren Bausteins sechseckigen oder viereckigen oder dreieckigen oder wabenförmigen Typs entstehen.

9. Verfahren zur Herstellung einer akustischen Vorrichtung, die eine phononische Kristallstruktur umfasst, nach einem der Ansprüche 1 bis 8, **dadurch gekennzeichnet, dass** die Einschlüsse sogenannte geschlossene Kegel sind, um das Stoppband maximal zu verbreitern.

10. Verfahren zur Herstellung einer akustischen Vorrichtung, die eine phononische Kristallstruktur umfasst, nach einem der Ansprüche 1 bis 9, **dadurch gekennzeichnet, dass**, dadurch dass die Einschlüsse mehrere Wandwinkel (θ₁, θ₂) aufweisen, es einen Definitionsschritt der geometrischen Parameter der Einschlüsse umfasst, der aufweist:
• das Bestimmen einer Funktion relativ zur Entwicklung der Frequenzpositionierung des Stoppbands mit den Wandwinkeln und/oder das Bestimmen einer Funktion relativ zur Entwicklung der Breite des Stoppbands mit den Wandwinkeln.

11. Verfahren zur Herstellung einer akustischen Vorrichtung, die eine phononische Kristallstruktur umfasst, nach einem der Ansprüche 1 bis 10, **dadurch gekennzeichnet, dass** die Einschlüsse in einer heterogenen Matrix realisiert sind, die einen Schichtenstapel umfassen kann.

12. Verfahren zur Herstellung einer akustischen Vorrichtung, die eine phononische Kristallstruktur umfasst, nach einem der Ansprüche 1 bis 11, **dadurch gekennzeichnet, dass** die Einschlüsse einer Reihe jeweils von mehreren übereinanderliegenden und/oder nebeneinanderliegenden Materialien gebildet sind.

13. Verfahren zur Herstellung einer akustischen Vorrichtung, die eine phononische Kristallstruktur umfasst, nach einem der vorangehenden Ansprüche, **dadurch gekennzeichnet, dass** die Struktur mehrere Reihen von Einschlüssen aufweist, die unterschiedlich sind.

14. Verfahren zur Herstellung einer akustischen Vorrichtung, die eine phononische Kristallstruktur umfasst, nach einem der vorangehenden Ansprüche, **dadurch gekennzeichnet, dass** die Struktur mehrere Reihen von Einschlüssen aufweist, die jeweils in unterschiedlichen Matrices realisiert sind.

15. Verfahren zur Herstellung einer akustischen Vorrichtung, die eine phononische Kristallstruktur umfasst, nach einem der vorangehenden Ansprüche, **dadurch gekennzeichnet, dass** die Einschlüsse Löcher sind.

16. Verfahren zur Herstellung einer akustischen Vorrichtung, die eine phononische Kristallstruktur umfasst, nach Anspruch 15, **dadurch gekennzeichnet, dass** die Einschlüsse aus teilweise oder vollständig mit Material gefüllten Löchern bestehen.

17. Verfahren zur Herstellung einer akustischen Vorrichtung, die eine phononische Kristallstruktur umfasst, nach einem der vorangehenden Ansprüche, **dadurch gekennzeichnet, dass** es ferner die Realisierung einer Bragg-Spiegelstruktur aufweist, die die phononische Struktur trägt.

18. Verfahren zur Herstellung einer akustischen Vorrichtung, die eine phononische Kristallstruktur umfasst, nach einem der vorangehenden Ansprüche, **dadurch gekennzeichnet, dass** die phononische Struktur eine zweidimensionale periodische Struktur ist.

19. Verfahren zur Herstellung einer akustischen Vorrichtung, die eine phononische Kristallstruktur umfasst, nach Anspruch 18, **dadurch gekennzeichnet, dass** das zweidimensionale phononische Kristall der Struktur eine Dicke in derselben Größenordnung wie der Bausteinparameter des Kristalls hat.

## Claims

1. A process for producing an acoustic device having a phononic crystal structure comprising a first series of inclusions produced in a first medium that are distributed in a matrix comprising a second medium, making it possible to block propagation of acoustic waves within a frequency band called the bandgap, **characterised in that** it includes the following steps:
- a step of defining the geometric parameters of said inclusions, said inclusions having walls in contact with said matrix, making at least one first angle (θ), called wall angle, non-zero to the normal of the plane of said structure, said geometiic parameters including said first wall angle, said step including:
• determining a function relating to the variation in frequency position of said bandgap with said wall angle and/or determining a function relating to the variation in width of said bandgap with said wall angle;
• determining said at least first angle (θ) for a selected frequency position and/or a selected width of the bandgap from the function or functions determined beforehand;
- a step of producing said first series of inclusions having at least said first wall angle in said matrix formed by said second medium.

2. The process for producing an acoustic device having a phononic crystal structure according to Claim 1, **characterised in that** the step of determining a function is formed by a 3D simulation operation carried out by finite elements and/or by experimental measurement.

3. The process for producing an acoustic device having a phononic crystal structure according to either of Claims 1 or 2, **characterised in that** the step of producing said first series of inclusions includes:
- depositing a layer of AIN material on a substrate;
- producing a resin mask over the layer of AIN material;
- an etching operation, which may be a dry etching operation, so as to define conical holes having at least said first wall angle in the layer of AIN material;
- removing the resin mask.

4. The process for producing an acoustic device having a phononic crystal structure according to Claim 3, **characterised in that** the dry etching operation is an RIE etching operation.

5. The process for producing an acoustic device having a phononic crystal structure according to either of Claims 1 or 2, **characterised in that** it comprises, on an SOI substrate comprising a top silicon layer on the surface of a silicon oxide layer;
- depositing a resin on the surface of the SOI substrate;
- defining etched features in said resin layer;
- a step of making said resin flow such as to orientate the etching features;
- an engraving operation on the top silicon layer through said orientated features in said resin such as to define conical holes having at least said first wall angle;
- removing said resin layer that has the etching features.

6. The process for producing an acoustic device according to any of Claims 1 to 5, **characterised in that** the inclusions have cross-sectional geometries of the circular or square or hexagonal or triangular type.

7. The process for producing an acoustic device having a phononic crystal structure according to any of Claims 1 to 6, **characterised in that** the phononic crystal structure has a periodic organisation, the series of inclusions being distributed periodically in the matrix.

8. The process for producing an acoustic device having a phononic crystal structure according to Claim 7, **characterised in that** the inclusions are located according to periodic arrangements obtained by repetition of an elementary lattice of the hexagonal or square or triangular or honeycomb type.

9. The process for producing an acoustic device having a phononic crystal structure according to any of Claims 1 to 8, **characterised in that** the inclusions are so-called closed cones so as to enlarge the bandgap to the maximum.

10. The process for producing an acoustic device having a phononic crystal structure according to any of Claims 1 to 9, **characterised in that** the inclusions having a plurality of wall angles (θ₁, θ₂), it comprises a step of defining the geometric parameters of said inclusions including:
• determining a function relating to the variation in frequency position of said bandgap with said wall angles and/or determining a function relating to the variation in width of said bandgap with said wall angles.

11. The process for producing an acoustic device having a phononic crystal structure according to any of Claims 1 to 10, **characterised in that** the inclusions are produced in a heterogeneous matrix that may comprise a stack of layers.

12. The process for producing an acoustic device having a phononic crystal structure according to any of Claims 1 to 11, **characterised in that** the inclusions of a series are respectively formed by a plurality of superposed and/or juxtaposed materials.

13. The process for producing an acoustic device having a phononic crystal structure according to any of the preceding claims, **characterised in that** said structure has a number of series of different inclusions.

14. The process for producing an acoustic device having a phononic crystal structure according to any of the preceding claims, **characterised in that** said structure has a number of series of inclusions respectively produced in different matrices.

15. The process for producing an acoustic device having a phononic crystal structure according to any of the preceding claims, **characterised in that** the inclusions are holes.

16. The process for producing an acoustic device having a phononic crystal structure according to Claim 15, **characterised in that** the inclusions consist of holes that are partially or completely filled with material.

17. The process for producing an acoustic device having a phononic crystal structure according to any of the preceding claims, **characterised in that** it further includes the production of a Bragg mirror structure supporting said phononic structure.

18. The process for producing an acoustic device having a phononic crystal structure according to any of the preceding claims, **characterised in that** the phononic structure is a two-dimensional periodic structure.

19. The process for producing an acoustic device having a phononic crystal structure according to Claim 18, characteiised in that the two-dimensional phononic crystal of said structure has a thickness of the same order of magnitude as the lattice parameter of the crystal.
